# EUROPEAN PATENT SPECIFICATION

(11) **EP 1 209 492 B1**
(45) Date of publication and mention of the grant of the patent: **04.02.2004**
(21) Application number: 00650200.9
(22) Date of filing: 28.11.2000
(51) Int. Cl.: G02B 6/12, G03F 7/00, G02B 1/04

(54) **Formation of materials such as waveguides with a refractive index step**
Herstellung von Materialien für Wellenleiter mit Stufenbrechungsindex
Procédé de préparation du matériau pour guides d'ondes à saut d'indice de réfraction

(43) Date of publication of application: 29.05.2002
(73) Proprietor: National University of Ireland Cork, Cork (IE)
(72) Inventor: Connell, Andrew, Cork, (IE); O'Brien, Shane, Mallow, Co., Cork (IE); Kelly, Patrick Vincent, Cork, (IE)
(74) Representative: Lane, Cathal Michael

(56) References cited:
- EP-A- 0 446 672
- EP-A- 0 661 558
- EP-A- 0 687 925
- WO-A-00/78819
- WO-A-98/26315
- WO-A-98/45759
- US-A- 5 080 962
- US-A- 5 265 185
- PATENT ABSTRACTS OF JAPAN vol. 014, no. 240 (P-1051), 22 May 1990 (1990-05-22) & JP 02 062502 A (ASAHI CHEM IND CO LTD;OTHERS: 01), 2 March 1990 (1990-03-02)

## Description

### Technical Field of the Invention

The present invention is concerned with a process of forming a refractive index step in a material such as for example in any structured element for instance diffractive optic elements and waveguides. The refractive index step is permanently formed. A buried or embedded waveguide may be formed by the process. The invention relates in particular to materials having formed therein a refractive index step.

### Background of the Invention

Many types of waveguides (including negative waveguides) are known and are used in various applications. Waveguides are used to propagate the transmission of electromagnetic waves and in particular microwaves. Waveguides may be of any desired shape. Traditionally waveguides were constructed of tubular metallic materials but more recently due to the use of higher transmission frequencies different types of waveguides have been developed. A "buried" or "embedded" wave-guide is one in which the guiding core is surrounded by material of a lower refractive index, e.g. a buffer layer and a protective layer. One example of the type of material being investigated for formation of wave guides includes photo-patterned sol-gel wave-guides produced using methacryloxypropyltrimethoxysilane which are discussed in three separate publications namely: H. Krug, F. Tiefensee, P. W. Oliveira and H. Schmidt, *SPIE Vol* 1758 *Sol-Gel Optics*, **1992**, 448; P. Coudray, J. Chisham, A. Malek-Tabrizi, C. Y. Li, M. Andrews and S. I. *Najafi, SPIE Vol 2695*, **1996**,92; P. Etienne, P. Coudray, Y Moreau and J. Porque,*Journal of Sol-Gel Science and Technology 13,* **1998**,523.

The technology referred to in these literature references is based around silane precursors containing alkoxy and methacrylate moieties. A 3-dimensional crosslinked matrix is formed via the hydrolysis and condensation of the alkoxy moieties under the influence of acid catalysts, as in typical in sol-gel thin film technologies. Further crosslinking is then selectively achieved by a photo-patterning technique that causes crosslinking across the methacrylate moieties in the exposed regions. The system employs a photoinitiator which produces free radicals on exposure to UV light which promotes cross-linking between certain moities. The areas in which methacrylate crosslinking have taken place have a higher refractive index than the unexposed regions. Thus a buried waveguide structure can be formed by this technique.

Cracking of films 5 microns thick, was observed when a film produced according to the literature reference P. Etienne, P. Coudray, J. Porque and Y Moreau, *Optics Communications 174*, **2000**, 413 were heated to the solder re-flow temperature of 250°C. Since in some instances the devices to which waveguides are attached, or form part, need to undergo solder re-flow at temperatures around 250 °C (for example a BCB (benzocyclobutene) planarisation layer may be exposed to 250 °C for 60-90 minutes), it is important that the films are thermally stable and that the refractive index does not change on heating. The observed deficiencies may be due to continued condensation which may be at least part attributable to the process used to prepare the waveguide.

The authors of the above-mentioned papers have also investigated the use of faster curing acrylates (see for example P. Etienne, P. Coudray, J. Porque and Y Moreau, *Optics Communications 174*, **2000**, 413).

While methacrylates are not preferred materials for reasons referred to herein, and as their free radical mechanism is susceptible to oxygen inhibition, (unless prepared in an inert atmosphere such as under nitrogen) waveguides may be prepared from these materials by the process of the present invention.

Thermal stability of organic/inorganic hybrid films has been investigated by the present inventor(s). In particular testing of a composition prepared according to the first literature reference above on a hot plate at 250 °C revealed very poor thermal resistance, inferior to many wholly organic polymers.

What appears to be actually produced by the methods described in the literature references immediately above is a methacrylate modified siloxane polymer formed by a sol-gel route. The films are produced from alkoxide precursors, like conventional sol-gels based on, say, tetramethoxysilane. As such, the processing is similar to normal sol-gel processing. The materials are easy to handle and can be reacted at room temperature and atmospheric pressure. The sol-gel reaction can be unpredictable and it produces an unstable sol whose viscosity increases over time. A non-liquid film (gel) is produced when further condensation occurs. Even after the gel point, there are very many uncondensed groups capable of reacting. In moderately thick films (of the order of a micron upwards) cracking can be observed by capillary stresses in films as they shrink. Another problem is that, even after heating the films at elevated temperatures for prolonged times, residual alkoxides and hydroxides will always be present. These residues may cause later cracking of the film.

US Patent No. 5,076,980 (Nogues et al) describes a method of making glass or ceramic optical elements in the form of sol-gel monoliths. The method provides the steps of:
(a) hydrolyzing and polycondensing one or more oxide precursors to form a sol comprising a plurality of oxide particles suspended in a liquid;
(b) casting the sol into a mold;
(c) gelling the sol by cross-linking the oxide particles to form a gel;
(d) ageing the gel to form an aged gel;
(e) subjecting the aged gel to a drying treatment. The drying treatment involves heating the aged gel in a high humidity environment; and then heating said aged gel in a low humidity environment to remove liquid from the pores of the aged gel to form a dried, aged gel, and
(f) densifying the dried, aged gel to form a sol-gel monolith.

Nogues *et al* are not concerned with the provision of a material with regions of differing refractive indices.

The stability of a refractive index step to temperature is recognised as a problem in US patent no 5,054 872 (Fan et al) to the production of photo-cured epoxies for wave-guide applications.

Wochnowskie *et al* Applied Surface Science 154-155 (2000) 706-711 describe photolytic modification of the refractive index of polymethyl methacrylate by employing UV laser light.

There therefore exists a need for an alternative process for producing waveguides, particularly waveguides which overcome at least some of the perceived disadvantages of those of the prior art.

### Summary of the Invention

The present invention relates to a process for forming a layer of material with at least two regions with differing refractive indices. The process comprises the steps as defined in attached claim 1.

The non-exposed region(s) are those region(s) not exposed to the conditions of step (c). The exposed region(s) are those (discrete region(s)).exposed to the conditions of step (c). Normally the gelable component is a polymerisable component. The skilled person will know what component(s) to select to create a gelable composition. This process allows the creation of a structure through which waves may be propagated. Typical waves carried include radio frequency waves such as microwaves.

Step (a) allows the gelable composition to be provided in a desired form, for example in a desired shape, of specific dimensions etc. The gelable composition could be provided in a film form so that the process results in the formation of a film structure suitable for use as a waveguide structure.

Step (b) allows for gelation to occur throughout the entire mass of the gelable composition so that a gel matrix is formed. It is not necessary to selectively gel the composition at the step (b) stage. It is desirable that step (b) results in the formation of a matrix such as by partial polymerisation for example by cross-linking. The partially gelled composition will thus have a matrix with an amount of ungelled material through it. The ungelled material will usually comprise one or more components of the gelable composition including an amount of ungelled gelable component. Generally speaking no selective exposure takes place during step (b) so that a matrix is formed throughout the mass of material while ungelled material remains within the matrix, again substantially evenly distributed throughout. The effect is to create a gel matrix or framework, within which ungelled material resides. The word "gelled" is used herein to refer to an interlinking network of material through a mass of material and resulting in a material of very high molecular weight and which is often referred to as of "infinite" molecular weight. The term "ungelled" refers to material of substantially lesser molecular weight which does not form part of an interlinked network. The ungelled material can be considered of finite molecular weight. "Partially gelled" refers to the state of a mass of material which contains gelled and ungelled materials. The ungelled material can contain material of high molecular weight which is not yet interlinked to the interlinking network.

Step (c) is selective. Following step (c) the amount of ungelled material in the exposed region is less than in the non-exposed regions. Little or no further gelation is induced in the non-exposed regions by step (c). Step (c) then creates the basis for forming regions of differing refractive indices, due to the differing amounts of gelation that have taken place.

Step (d) exploits the differences (created by step (c)) in the amounts of gelation by extracting ungelled material. In the event that the exposed regions have been completely gelled, substantially no extraction of ungelled material will take place from the exposed regions. This is due to the fact that virtually all of the gelable component will have been incorporated into the gel structure so that little or no material is available for extraction.

The unexposed region(s) will yield (on extraction) at least some of the ungelled material, so that a refractive index difference is created between exposed and unexposed regions. One theory suggests that voids are created in the unexposed region(s) (by removal of material on extraction) so that these region(s) have a different refractive index from the exposed region(s). It will be clear to those skilled in the art that this effect is achieved by differing extents of extraction. In other words it is not critical that no extraction from the exposed region(s) takes place. Provided that different amounts of extraction are achieved between the exposed and non-exposed region(s) (so that a compositional and usually a physical structural difference exists), the method of the invention will create the desired material. In other words and in general more extraction occurs in the non-exposed region(s) as compared to that in the exposed region(s) when the waveguide material is uniformly exposed to extraction.

If desired, but not essentially, a second component may be provided to form part of the gelable composition, together with the gelable component e.g. a difunctional reactive component such as diphenyl dimethoxy silane. Desirably the gelable component and the second component can be combined to form a non-solid mixture, e.g. a liquid mixture. Usually the second component will have a refractive index distinct from the refractive index of a gel of the gelable component not incorporating the second component. However any second component which may be used to amplify the refractive index difference or create the areas of differing refractive indices may be selected. The second component is selected to impart a higher or lower refractive index so that part of the gelled material in which it is incorporated. The amount of the second component extracted from the non-exposed region(s) is greater than the amount extracted from the exposed region(s). Again it is a matter of degree of extraction. The amount of second component selected for incorporation into the composition to create a gelled gelable component/second component matrix which has a different refractive index from the unexposed regions. The unexposed region(s) may also have extracted an amount of the ungelled component aiding creation of a refractive index difference. In one embodiment, only second component is selectively extracted by the extraction step.

If a second component is used it is desirable that the second component and the gelable component are miscible. For example the second component and the gelable component may form a dispersion, for example a sol. The second component is usually dispersed or mixed into the gelable component. The gelable composition may be a sol so that the final gelled product may be considered a sol-gel.

In the arrangement according to the invention the material is provided with two or more regions having two or more refractive index values and desirably may have a step change in refractive index between at least two regions of the material. The step provides a distinct transition between the regions of different refractive indices. The step is desirably linear and in a desirable arrangement is created running (perpendicularly) from the top of the waveguide structure to its base. It will be appreciated that the theoretical ideal of a complete transition from a material having one refractive index value to another without regions of intermediate refractive index values is desirable. In practice however less than ideal formations are satisfactory and the products of the method of the present invention provide very useful structures.

In step (d) the second component (where present) may be extracted as a dispersion within ungelled gelable component, or in a form where it is mixed with the gelable component. An amount of the second component not bound in the material by step (d) may be extracted in step (d). Ungelled material and/or second component may be easily extracted, for example by (washing with a) solvent. The partially gelled product of step (b) may form an insoluble network within which quantities of the dispersion remain. The partial gelation step forms a mass convenient for subsequent processing for example to which a mask may be easily applied. Amounts of the second component become immobilised or bound within the gel structure formed by the gelled gelable component while in areas of lesser extents of gelation lesser amounts are immobilised or bound into the structure. Washing of the entire mass of material may thus be used to selectively remove relatively greater amounts of second component material from the partially gelled regions.

In a preferred process of the invention the gelable component is a polymerisable component and is desirably one which is susceptible to cross-linking. This attribute ensures that after step (b) has been carried out, where the gelable component is cross-linkable the second component may be incorporated in to the cross-linked structure. The partial gelation and more complete gelation processes may be a cross-linking process. The second component chosen is thus desirably bindable in a polymer network such as a cross-linked structure. The material at this stage will have some cross-linked structure formed by cross-linked material and some non-cross-linked material. This structure is considered partially gelled. The gelable component will have usually at least three functional groups which may be the same or different. Two functional groups will take part in a polymerisation reaction to form a polymer chain while the third takes part in the cross-linking reaction. For example three hydrolysable groups could be present. After step (c) is carried out the discrete region(s) exposed to the conditions selected, will have cross-linked to a greater extent. Ease of removal of ungelled gelable component and/or second component from the product of step (c) occurs to different extents depending on the amount of cross-linking within the structure. Accordingly, more of, and desirably substantially all of, the second component (where present) located in the regions of lesser cross-linking can be selectively removed for example by extraction by a selected chemical extraction. Extraction can be achieved for example using a solvent. Washing with (including immersion in) a solvent *per se* would not normally achieve a selective extraction but due to the differences in the physical structure, material may be selectively removed by washing for example from less intensively cross-linked areas. This effect is easily achieved for example where the second component is at least partially cross-linked or otherwise bound within a cross-linked structure of gelled gelable component. The solvent selectively removes non-cross-linked (and/or second component) within the partially cross-linked regions while the more completely cross-linked regions(s) contains substantially less uncross-linked material so extraction does not occur to the same extent. Extraction of ungelled gelable component and/or secondary component to a greater extent from the partially cross-linked areas thus occurs while that in the more fully cross-linked area is extracted to a lesser extent with the resultant creation of areas of differing refractive indices.

The gelable composition may be non-solid, typically a low or high viscosity liquid which will allow for ease of mixing of the second component (where present). In one desired arrangement the gelable composition is polymerisable by irradiation and/or by exposure to elevated temperatures and/or by exposure to electron or ion beams. Desirably the composition is gelable by heating and crosslinkable by irradiation. Such gelable compositions are useful in the processes of the present invention as a mask may conveniently be used to expose discrete region(s) of the product of step (c) to conditions which induce more complete gelation of the partially gelled composition. A mask provides a very convenient way of providing selective exposure to a radiation source such as U.V. radiation. The mask may be designed to any desired pattern. Selective exposure by the mask will achieve gelation in the desired discrete areas. One convenient gelable composition is gelable by UV irradiation. A gelable component which is gelable by UV irradiation is particularly convenient and for example particularly it may be gelled by exposure to UV light in the range from about 100 nm to about 400 nm.

Desirably the gelable component is selected from an alkyl or acyl substituted alkoxysilane containing an oxirane, methacrylate or acrylate moiety, examples of which are given below:
(3-glycidoxypropyl) trimethoxysilane;
(3-glycidoxypropyl) triethoxysilane;
(3-glycidoxypropyl) methyldimethoxysilane;
(3-glycidoxypropyl) methyldiethoxysilane;
(3-glycidoxypropyl) dimethylmethoxysilane;
(3-glycidoxypropyl) dimethylethoxysilane;
2-(3,4-epoxycyclohexyl) ethyltriethoxysilane;
2-(3,4-epoxycyclohexyl) ethyltrimethoxysilane;
epoxypropoxypropyl terminated polydimethylsiloxanes such as epoxycyclohexylethyl methylsiloxane-dimethylsiloxane copolymers;
methacryloxypropyltrimethoxysilane;
methacryloxypropyltriethoxysilane;
methacryloxypropylmethyldimethoxysilane;
methacryloxypropylmethyldiethoxysilane;
methacryloxymethyltrimethoxysilane;
methacryloxymethyltriethoxysilane;

2-hydroxy ethyl methacrylate;
2-hydroxy 3-methacryloxy propyl methacrylate;
3-hydroxy propyl methacrylate;
tetrahydro furfuryl methacrylate;
zirconium tetramethacrylate;

acryloxypropyltrimethoxysilane;
acryloxypropylmethyldimethoxysilane;
2-hydroxy ethyl acrylate;
3-hydroxy propyl acrylate;
2-hydroxy 3-methacryloxy propyl acrylate;
2-hydroxy 3-acryloxy propyl acrylate;
diethylene glycol diacrylate;
triethylene glycol diacrylate;
tetraethylene glycol diacrylate;
trimethylol propane triacrylate;
1-6-hexanediol diacrylate;
tetrahydro furfurylacrylate;
zirconium tetraacrylate; and
UV cross-linkable low molecular weight polymeric precursors, for example XP SU8 (Bisphenol-A-novalac resin) available from Chestech MicroChem Corp., 1254 Chestnut Street, Newton, MA, USA; and
epoxypropoxypropanol terminated polydimethylsiloxanes such as products DMS-E01, DMS-E12 and DMS-E21 from Gelest Inc, Tullytown, PA, USA.

The compounds above are precursor materials which are uv-cross linkable with the aid of photoinitiators.

Preferably the second component of the gelable composition is a component having a higher refractive index than the gelable component though the skilled person will appreciate that the second component may have a lower refractive index than the gelled gelable component. The second component may be considered a refractive index tuning or altering component. The second component may be a high refractive index component for example complexes of Transition metals such as Zr or Ti such as Zr tetramethacrylate or may be a suitably selected polymer. The second component (usually a high refractive index component) desirably is one which is capable of taking part in the step (c) gelation reaction. In this respect the second component will usually have at least two functional groups which will allow it to be incorporated into for example a cross-linked structure. The exposed region(s) will desirably have a greater amount of second component bound in the gel (matrix) and also have a higher refractive index than non-exposed region(s) with a lesser amount of second component bound in the gel (at a desired wavelength. The second component may comprise solid particles. The high refractive index component may thus become part of the gel matrix for example as part of a polymer chain such as along a polymer backbone or crosslinked between polymer chains. The high refractive index component may be a silane e.g. a phenyl-substituted silanes. Phenyl substituted silanes are useful as the second component for a number of reasons: (i) if a photoinitiator is required as part of the gelable composition, phenyl substituted silanes may assist dissolution of the photoinitiator; (ii) phenyl substituted silanes assist in imparting a high refractive index step in the material, (iii) they contribute to thermal stability (at least in the areas into which they have been incorporated) over time. Suitably the silane is selected from those disclosed above in particular phenyl substituted silanes.

The difference between the refractive index of the exposed region(s) and the non-exposed region is usually in the range of about 1 to about 6 such as from about 13 to about 3. These values have been determined according to the prism couples method described in "Refractive Index Measurements of Mixed HgBrₓI₂₋ₓ Single Crystals", Optical Materials, Volume 14, 2000, Pages 95-99. V. Marinova, St.Shurulinkov, M. Daviti, K.Paraskevopoulos and A. Anagnostopoulos.

Suitably the second component is present in amounts from 1 mol% to 50 mol% more usually 5 to 40 mol% based on the molecular weight of the gelable component.

The skilled person will know which gelable components will work well with the particular solid particles selected as second component. It is desirable that where the second component comprises solid particles they disperse well through the gelable component.

The gelable component may include a polymerisable monomer or oligomer or mixtures of either or both. If desired the gelable composition may include an initiator to initiate polymerisation. Other components such as accelerators, stabilisers, thixoropic agents, dyes, diluents etc. may be added as desired.

One particular process, which is suited in particular to the formation of a material suitable for use as a waveguide, includes the following steps:
(i) forming a buffer layer on a desired substrate;
(ii) applying a gelable composition comprising a gelable component to the buffer layer so that the gelable composition is in a desired form;
(iii) exposing the gelable composition to conditions which partially gel the gelable composition so that the amount of ungelled material remains;
(iv) exposing at least one discrete area of the partially gelled product of step (iii) to conditions which induce more complete gelation of the partially gelled gelable composition so that more ungelled material is incorporated into the gel structure in the exposed regions than in the non-exposed regions; and
(v) extracting material not incorporated into the gel structure at least from that region not exposed to the conditions of step (iv).

In the present invention following extraction even further gelation of the gelable composition may be induced by exposure to conditions which induced even further gelation of the gelable composition. This latter step may be carried out non-selectively for example without a mask.

After a refractive index variation has been achieved by the creation of voids of dimensions which can be considered to be on a micro scale. The voids may be referred to as "microvoids" which can be created by extraction of material which does not form part of the gel structure material, as outlined above. The material comprising the device may be then fully cross-linked by further exposure to UV radiation and/or heating. Since no unreacted reactive components remain in the deposited material, further heating causes no further change in refractive index. The material will then most usually be in the form of a film or membrane which is most usually a solid and which can be flexible. The gelable composition is selected to form, under the conditions of the process of the invention a material through which a selected radiation is transmissible.

Advantages of certain aspects of the processes within the present invention include: the invention overcomes the difficulties in making a buried (planar) waveguide by retaining a cladding part of the waveguide layer in the case where at least two discrete regions are exposed to the conditions of step (c) of the process. The cladding part referred to is the portion of material (usually) of lower refractive index which lies between areas of (usually higher refractive index) - often referred to as "the guiding regions". A top protective layer and a bottom buffer layer may be made by known methods.

The invention overcomes the difficulties in making a buried or planar waveguide which is thermally stable by:(a) chemically fixing the refractive index step introduced in one aspect of the invention by ultraviolet irradiation through a mask by means of a patterned compositional variation (as opposed to reliance on refractive index variation between reacted and unreacted moieties e.g. vinyl or epoxy groups); (b) employing a waveguide layer material with a high thermo-mechanical stability (over a device lifetime).

The invention also relates to the waveguide obtainable by a process according to the present invention.

### Brief Description of the Figures:

Figures 1 to 6 show a diagrammatic representation of certain stages of one embodiment of a process of the invention in which:
Figure 1 shows a substrate on which a waveguide structure is to be formed;
Figure 2 shows the substrate of Figure 1 with a buffer layer applied thereon;
Figure 3 shows the structure of Figure 2 on which a gelable composition comprising a dispersion of a second component in a gelable component has been applied and exposure of the structure to conditions which partially gel the gelable composition;
Figure 4 shows the selective exposure of discrete areas of the structure of Figure 3 to conditions which induce more complete gelation utilising a mask;
Figure 5 shows the structure of Figure 4 with the mask removed and the further optional step of further exposure to conditions which induce even more complete gelation of the gelable composition;
Figure 6 shows the structure of Figure 5 to which a further (protective) layer has been applied;
Figure 7 shows a plan view from above of a waveguide structure which has been created using a more complex mask.

### Detailed Description of the Figures:

The invention is now described in greater detail with reference to the drawings referred to above. The invention provides a process of forming a permanent refractive index step in a material. The invention may be used to provide a buried waveguide structure. One convenient method of doing so is by using a combined irradiation patterning and chemical extraction process. In particular planar waveguides may be provided.

The process of the invention is particularly useful for the production of a "buried" or "embedded" waveguide structure.

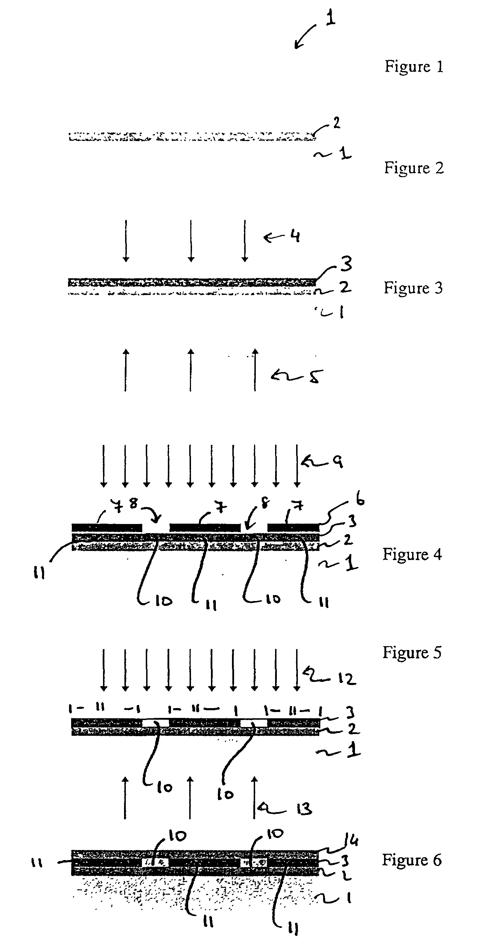

Figure 1 shows a substrate 1 on which a waveguide structure is to be formed. Typical substrates include glasses, ceramics, semiconductors such as silicon wafers, and polymers. As shown in Figure 2 a buffer layer 2 is formed on the substrate 1. The buffer layer may be made by any suitable process as will be selected by the person skilled in the art. Typical materials for forming a buffer layer are glasses and other materials such as ceramics semiconductors and polymers including plastics. Typical processes for forming a buffer layer are well known to those skilled in the art. Normally the buffer layer has a thickness of 1µm to 10µm. It is usual that the buffer layer is made of a material which is optically transparent at the wavelength at which the waveguide is to be used.

A layer or coating 3 of a gelable composition which optionally includes a second component dispersed in the gelable composition, the second component having a refractive index value distinct from the refractive index value of a gel (polymer) of the gelable composition (without the second component present), is applied to the buffer layer 2 in a manner similar to the application of the buffer layer 2 to the substrate. Conveniently a sol-gel may be used. In the embodiment the gelable component is photopolymerisable being photosensitive at certain wavelengths (generally although not exclusively in the ultraviolet range 100 nm - 400 nm). If necessary or desired the gelable composition may include a photoinitiator component. The photoinitiator component may be selected from any suitable photoinitiator such as onium salts which normally function as cationic initiators, and free radical photoinitiators such as β diketones. Examples of onium salts include the following:
diazonium salts;
diaryliodonium salts;
diarylbromonium salts;
triarylsulphonium salts;
triarylselenonium salts;
dialkyl-4-hydroxyphenyl-sulphonium salts;
ferrocenium salts and thiopyrylium salts.

Typical salts include those with one or more of the following anions:

BF⁻₄, PF⁻₆, AsF⁻₆, SbF⁻₆

Examples free radical initiators in particular β-diketones include alkyl-, alkyl phenyl-, phenyl- and di-ketones) such as benzophenone; xanthone, acetophenone, anthraquinone, . 4,4-dichlorobenzophenone, 4-benzylbenzophenone, benzoylformic acid biacetyl and benzoyl phosphine oxides, and other species with double oxygen bonds on 2 or more adjacent atomic constituents. Where the term "alkyl" is used with reference to the present invention any alkyl group may be used but desirably the alkyl group is a C₁ - C₂₀ group for example a C₁- C₁₀ group. Where the term "aryl" is used any aryl group is useful but the aryl group is desirably a C₃ - C₃₀ group (including hetrocyclic groups) more particularly a C₆-C₂₀ group. Where the term "acyl" is used any acyl group is useful such as a C₁ - C₂₀ acyl group for example a C₁ or C₁₀ acyl group.

Alternatively a gelable (polymerisable) monomer or oligomer which is gelable (polymerisable) without the necessity for addition of an initiator in the composition, under the conditions to which it is exposed e.g. photopolymerisable. Where a two-component starting material is used it may for example be formulated so that Zr, Ti or other metal or other high refractive index component or reactive moiety (e.g. phenyl-substituted silane) can be trapped by polymerisation mechanisms such as cross-linking when irradiated. In one embodiment of a process of the invention the gelable component may be partially cross-linked by an irradiation and/or thermal process. Thermal processes may be more suitable for this step as dissipation of heat through the mass of material may be more readily achieved than for example of UV radiation which has a lesser tendency to dissipate.

As shown in Figure 3 the partial gelation of the layer 3 of the starting material is achieved by exposure of the layer 3 to conditions which include partial gelation. In the embodiment this is achieved to exposure to relatively low intensity (typical intensities are in the range of 1 to 30 mW/cm²) uv radiation (indicated by arrows 4) (and of a suitable wavelength generally in the range of 150 to 400 mm) and optionally additionally or alternatively heat energy (indicated by arrows 5). This partial gelation step forms an insoluble network containing amounts of the ungelled gelable component (and if used second component). In the embodiment the particular gelation which takes places is a polymerisation for example polymerisation by a condensation reaction. The matrix or network thus formed typically has a consistency comparable to a soft-solid or a very high viscosity liquid having in its matrix small amounts of the ungelled gelable component (and if used second component). The ungelled gelable material may take the form of uncross-linked material which is more soluble (for example in common solvents) than the matrix itself.

A mask 6 is then placed over the partially gelled layer 3. The mask 6 is patterned as desired. The mask 6 is provided in particular with uv opaque regions 7 and uv transmission regions, in the form of apertures 8, defined in the mask 6. In the embodiment the areas of the layer exposed by the mask will, after the process, have a higher refractive index relative to the areas of the layer which are masked from the exposure.

Discrete areas of layer 3 are exposed (selectively) to a high flux of ultraviolet radiation (indicated by arrows 9) through the mask 6 to more completely polymerise (in the embodiment cross-link) exposed regions 10 of the layer 3. This locally traps the second component such as the metal complex or other high refractive index component. In the unexposed regions 11 (beneath the region 7 of the mask 6), the degree of gelation (cross-linking) will be much lower, rendering the material remaining in those parts of the layer 3 susceptible to extraction for example by chemical extraction.

In particular following the selective exposure to actinic radiation more complete gelation of the layer 3 using mask 6 the structure seen in Figure 5 is formed. In Figure 5 the mask 6 has been removed so that the structure shown includes the substrate 1, the buffer layer 2, and the layer 3 which is now selectively gelated to varying extents. In particular regions 11 are partially gelled while regions 10 are gelled to a substantially greater extent. The ungelled material (including where present the second component) may then be extracted from regions 11 of the layer 3 to a different (usually greater) extent than from regions 10. Due to the differing amounts of polymerisation which has been achieved as between regions of the material selective extraction may be achieved, for example by washing with (immersion in) a suitable solvent. Solvent extraction is not usually by itself selective. Substantially lesser amounts of extraction of the second component from regions 10 is achieved while sufficient amounts of the second component may be extractable from the regions 11 to provide a refractive index step between each of regions 10 and its adjacent region(s) 11.

Therefore a refractive index step is permanently fixed between the exposed (higher refractive index) and unexposed (lower refractive index) regions. A linear transition between the regions is created. The layer 3 deposited on top of the buffer layer has become a layer suitable for use as a waveguide layer.

As shown in Figure 5 and if desired, further gelation (polymerisation) such as by cross-linking can be achieved by exposing the entire layer 3 to the conditions which induce even more complete gelation of the gelable composition for example exposure to an even higher intensity uv light source (indicated by arrows 12) and/or additional heat (indicated by arrows 13). A mask is not required during this latter step as the refractive index step has been permanently fixed by the extraction process. As shown in Figure 6 a protective layer 14 may be formed on top of layer 3. Suitable protective layers include those formed from benzocyclobutene. The protective layer may be applied in a sol gel form by conventional processes such as spin or dip coating. Suitable materials for formation of protective layers are known to those skilled in the art.

The structure of waveguide formed by the process of the invention just described can be considered a ridge waveguide.

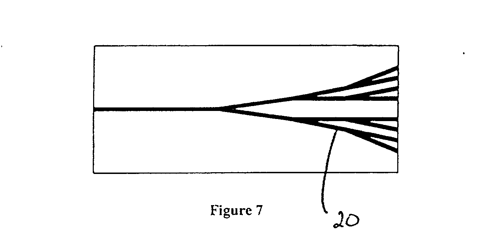

Figure 7 shows a complex waveguide pattern (viewed from above) which illustrates that more complex waveguide patterns than those of Figures 1 to 6 can be created by using a complex mask. The refractive index step is indicated by the lines 20.

A buried wave-guide may be produced by selectively gelling (crosslinking) the exposed part of the film to increase its refractive index relative to the surrounding layers (the cladding). Methacrylates cross-link under the influence of heat, so the refractive index step may be lost for waveguides constructed of these materials at solder re-flow . temperatures. Thin films made from unsaturated monomers and crosslinked with free radical initiators are very prone to oxygen inhibition. If the films are not protected from the atmosphere during heating, the free radicals formed due to thermal excitation will effectively be "mopped up" by the atmospheric oxygen. Thus, whilst further cross-linking may be avoided, a sticky surface comprising of thermally unstable peroxides and hydroperoxides will be produced. For instance the high functionality of the methacryloxypropyltrimethoxysilane precursor (3 methoxy groups take part in the condensation reaction) may cause the incipient point of gelation to occur too early. Further condensation occurring later on may cause the matrix of the solid film to shrink causing stresses in the matrix which may lead to cracking. Furthermore by-products eliminated during the condensation reaction after the solid film is formed (such as alcohol and water) may impose capillary stresses which may cause the matrix to crack. It is believed therefore that the maximum thickness of crack-free films produced using the method(s) disclosed in the above literature references is of the order of 5 microns. The film produced does not bear up well to heat testing. Furthermore it is believed that due, at least in part, to the presence of unreacted methacrylate in the layers formed the material is susceptible to loss of the refractive index step on exposure to heat due to further induced polymerisation of the methacrylate component. This may take place in the cladding regions about the waveguide reducing the refractive index between the guiding and cladding regions. It is thus difficult to achieve a reference index step with the method described in the above literature references which is stable over time and to the conditions to which it may be exposed. Accordingly while many gelable (polymerisable) components may be used it is desirable for applications where the waveguide may be subjected to high temperatures etc., it is desired that the gelable component is selected from:
acryloxypropyltrimethoxysilane;
acryloxypropylmethyldimethoxysilane;
2-hydroxy ethyl acrylate;
3-hydroxy propyl acrylate;
2-hydroxy 3-methacryloxy propyl acrylate;
2-hydroxy 3-acryloxy propyl acrylate;
diethylene glycol diacrylate;
triethylene glycol diacrylate;
tetraethylene glycol diacrylate;
trimethylol propane triacrylate;
1-6-hexanediol diacrylate;
tetrahydro furfurylacrylate; and
zirconium tetraacrylate;

The second component may be selected from non photoreactive compounds which form part of the composition. Precursors which are not cross-linkable by uv are also useful e.g. diphenyl dimethoxysilane, tetramethoxysilane, tetraethoxysilane and other such silanes.

An alternative to the use of methacrylates is the use of acryloxysilanes.

Acrylates are known to cross-link much faster than methacrylates under the influence of UV light, and are useful in this regard. Useful acryloxysilanes include those described above.

A further group of materials which may be used in the process of the present invention include glycidoxy silanes. Suitable glycidoxy silanes are described above. These materials contain an oxirane or epoxide group. These materials are preferred as a substitute for methacrylates due in part to the fact that epoxide polymers, per se, are very thermally stable.

Cationic polymerisation is desirable mechanism for effecting gelation (cross-linking) of the composition. It is possible to photo-cure epoxies via a cationic polymerisation in which a Lewis acid catalyst is formed from a photosensitive compound (triaryl sulphonium/ hexafluoroantimonate salt) under the influence of UV light, which reacts with the oxirane ring. Wholly organic epoxies produced by such a reaction can be thick (over a millimetre) and are tack-free, since atmospheric oxygen does not appear to inhibit the crosslinking reaction, as is does with free radical vinyl polymerisation. An additional desirable effect which can be achieved with the present invention is that the gelation reaction (the photo-crosslinking reaction) does not "spread" under the mask to any substantial extent, as is often observed with free radical cured, negative photoresists. This "non-spreading" phenomenon can be achieved with many gelable compositions including hybrid sol-gel containing oxirane rings. It is thus possible to produce more symmetrical waveguides, which will minimise optical losses. The patent literature describes the use of wholly organic photo-cured epoxies in wave-guide applications. Interestingly, with this technology it is found that the refractive index step occurs in the opposite direction, with the exposed areas of the polymer film having a lower refractive index than the uncured areas.

It has been found that glycidoxy silanes such as glycidoxypropyltrimethoxysilane if mixed with at the initial condensation stage with at least one difuncitional silane delays the onset of gelation so that the reactants can be more fully condensed before deposition of a film of the material, which in turn minimises shrinkage of the matrix when the last of the condensable groups are finally consumed. Additionally, the difunctional silanes impart a degree of flexibility. Both effects minimise cracking of the cured matrix or gel. By using a phenyl containing silane as the difunctional reactant, it is possible to increase both the refractive index and the thermal stability of the matrix.

The following mechanisms are postulated to potentially explain the refractive index step where the solvent extraction (immersion) process does not extract significant amounts of any component but physically or chemically effects the differing regions to differing extents, such as for example by creation of a discolouration in the non-exposed regions. e.g. a milky appearance to different extents in the structure. The solvent may be any suitable fluid including supercritical fluids.

A non-crosslinked gel (or sol-gel) composition containing a higher proportion of high refractive index phenyl containing species are useful, since phenyl substituted alkoxides react more slowly than such as phenyl alkoxides such as 3-glycidoxytrimethoxysilane or dimethyldimethoxysilane. Hence, in the extracted areas, the refractive index will be lower than in the fully crosslinked areas.

The process of solvent extraction removes material in the non-crosslinked regions thereby producing (sub-microscopic) voids which give the extracted regions a lower refractive index than the fully crosslinked areas where substantially no material may be extractable. If the voids are small enough no light scattering will occur.

The extracted areas are not as completely crosslinked as the wave-guide areas where photoinitiator is present photoinitiator may also/alternatively removed during the solvent extraction phase. Removal of the photoinitiator in this manner is likely although further crosslinking of the film can occur on UV exposure since the material has been observed to become noticeably harder.

Where initial gelling can be achieved by a condensation reaction the gel (or sol-gel) condensation reaction is desirably carried out until the viscosity of the gel (or sol-gel) is sufficiently high for dipping or spinning for example 0.05 to 100 Ns/m² desirably 0.1 to 10 Ns/m² (measured using a Brookfield viscometer at 25°C using ICP-TM-650 standard method - Association of Connecting Electronics Industries). A film is deposited by spin or dip-coating and 'dried' by heating it to a temperature higher than about 70°C. Once gelled, a continuous matrix is formed. Within this continuous matrix (the gel), there exist lower molecular weight, mobile species (which may be the sol), which exist up until the film is completely cured. If it is deemed necessary after initial partial gelation (e.g. if the film is still slightly tacky) further reaction can be achieved by more completely but still not fully crosslinking the whole film by exposing it to UV light briefly. Thermal part-gelation of the gelable composition is preferable due to the ease of dissipation of heat throughout the mass of the starting material. It is important, however, that some ungelled gelable component remains. A suitable mask is placed over the film and the guide layers are fully cured by exposing them to UV light for a period (typically in the range of 10 seconds to 10 minutes). UV is useful in this step as UV light has a lesser tendency to dissipate than heat so that substantially no polymerisation occurs in unexposed regions. There is no necessity to use an excimer lamp. The photo-active compound could be an effective catalyst for both oxirane ring opening and silanol condensation reactions. The film is then immersed in a solvent in order to extract the ungelled (or sol) material. The solvent molecules are able to penetrate the matrix and will remove the ungelled material from the film but will not remove any species chemically bonded to the matrix. The extracted parts of the film then possess a lower refractive index than the fully cured guide layer, as the material extracted will contain a higher quantity of the high refractive index component.

The whole film is then exposed to a high dose of UV radiation to fully cure the remaining under cured regions. Because the refractive index step exists due to a composition variation, it will be more stable to the effects of temperature than one which exists due to a difference in the degree of crosslinking. Also, the magnitude of the step can be made much larger.

The method of partial extraction to obtain a desired composition, and hence, refractive index may also be applicable to methacrylate and acrylate-based systems. Potentially, the method lends itself to obtaining a larger refractive index step than is possible by using existing "Coudray-type" technology in the literature references above.

Another way of incorporating the phenyl (or other high refractive index component) into the matrix will be to add it to the sol-gel as a "diglycidylsilyl compound" in which the high refractive index phenyl component is terminated at each end with an epoxy group. In this instance the compound will be added to the sol-gel afterwards. Because the compound contains no condensable groups, it will only be incorporated where the film is exposed to UV light. In the unexposed regions it will be possible to extract completely this compound. This approach may lend itself to creating a more reproducible refractive index step.

If methacryloxypropyltrimethoxysilane is used (this system is thought to produce lower optical losses than the epoxide containing sol-gels), the partial extraction is useful. An example is in the creation of a large and stable refractive index step, such as when the zirconium is added in the form of a methacrylate, for example zirconium tetramethacrylate. Since this material contains no condensable groups, it should be added during the photocuring stage. After patterning and extraction with solvent, all of the non-photo-cured zirconium tetramethacrylate will be removed. Then the system is:
a) Not prone to precipitation during sol-gel preparation
b) Allows a potentially huge refractive index step to be created.

The materials identified for employment in the method of the invention are exemplary only and the skilled person will know other materials which will be suitable for use within the method of the present invention.

### Example 1

The following ingredients were placed into a small plastic beaker:
Dimethyldimethoxysilane 3.62g; Diphenyldimethoxysilane 7.32g;
3-glycidoxypropyldimethoxysilane 9.46g;
2 ml of 0.1 M HCl was added to the above over a period of 5 hours.

Some precipitate was formed, believed to be diphenylsilanediol. This disappeared on heating to 50°C. After stirring the above at 50°C for 2 hours, the solution was cooled to 20°C. The solution remained clear. 0.9g of a 50% solution of triarylsulphonium/hexafluoroantimonate salt in propylene carbonate was then stirred into the mixture for 30 minutes.

At this stage, the mixture was of a low viscosity and was poured onto a silicon wafer to form a film of approximately 5- 10 microns thickness. The mixture was dried by heating for 40 hours at 70°C and a further 2 hours at 100°C, after which the film was touch dry. The whole film was partially cured by exposing it to 40 light units from a DEK 1600 Exposure System (DEK Printing Machines Ltd., Weymouth, Dorset,U.K.). This machine has a broadband UV, non-collimated light source. The measured intensities at 365 and 405nm are 7.6 mW/cm² and 25.7 mW/cm² respectively. The light unit detector provides the same dose of radiation over a prolonged period by accounting for the loss of efficiency of the UV lamp. It is believed that 40 light units = 1 minute and 23 seconds. All of the following examples employed this UV source. The film was then left for 2 hours to allow the cure to develop further. This is because a living polymer system is formed from the above initiator, and curing continues on the removal of the UV light source. The waveguide areas were then fully exposed using a chrome on quartz contact for a further 200 light units. The wafer was then extracted in toluene for 2 hours and dried. The waveguide regions which were not previously visible were now visible to the naked eye. Further curing of any remaining epoxide groups was effected by exposing the whole film to a further 200 light units.

The thermal stability of the film was checked by placing the wafer on a hotplate in air at room temperature and ramping the temperature from 20°C to 250°C over a period of approximately 30 minutes. The wafer was maintained at this temperature for a further 45 minutes before removing it and placing on a cold surface. Surprisingly, no cracks appeared in the film, and the waveguide structures were still visible. The wafer was cleaved in several places to provide sections for examination of film thickness. No peeling was observed during cleaving or subsequent polishing, indicating excellent adhesion to the wafer. The thickness was found to be 5-6 microns. The adhesion was further found to be excellent by performing a "Scotch tape test". The film produced was hard and remained unmarked when pressure was applied to it using a 2H pencil.

It was suspected that a desired amount of the diphenyldimethoxysilane was not incorporated into the formulation due to its low reactivity. This may be overcome using a higher acid concentration.

### Example 2

The following ingredients were placed into a small plastic beaker.

Dimethyldimethoxysilane 5.41g; diphenyldimethoxysilane 10.99g; 3 glycidoxypropyl dimethoxysilane 14.18 g

To the above mixture, 10 ml of 0.1 M HCI were added dropwise over a period of 1 hour. After 16 hours had elapsed a further 5ml of 0.1 M HCl were added. The mixture then became cloudy due to the precipitation of diphenylsilanediol. Methyl ethyl ketone (MEK) was added to provide a clear solution and the reaction was continued by heating at 50°C for 2 hours. The mixture was then heated to 85°C for 2 hours to drive off any remaining volatiles ( i.e. water and solvent) to produce a clear viscous polymer which solidified on cooling. The solid polymer was then redissolved in MEK to provide a viscous liquid. To the above, 1.13g of a 50% solution of triaryl sulphonium/hexafluoroantimonate salt in propylene carbonate were added. The formulation was then spun onto a 100 mm(4") silicon wafer at 1000 r.p.m. for 5 minutes to provide a film with a thickness of between 75 and 100 µm. The film was then dried for 2 hours at 50°C. The film was then partially cured for 100 light units and allowed to stand for 2 hours. The waveguide regions were formed through a chrome on quartz mask by exposing for 400 light units. The wafer was then immersed in acetone for 3 hours to extract the soluble material. The waveguides became more obvious after extraction. Finally, the whole film area was exposed to a further 400 light units to further advance crosslinking. The film produced in this example was softer than that produced in Example 1 due to the inclusion of a higher proportion of the diphenyldimethoxysilane component. In both of the above examples it is postulated that the refractive index step was produced by the creation of microvoids and/or the removal of the soluble higher refractive index diphenyl component. That is, a compositional variation between the waveguide regions and the cladding regions may have been induced by the extraction process.

### Comparative Example 3 - Production of Ridge Waveguides

The formulation used in Example 2 was spun onto a wafer and dried. The film was exposed to waveguide patterns through a chrome on quartz mask for 400 light units. The non-crosslinked species (the unexposed areas) were removed by immersing the wafer in acetone. The waveguide structures formed were 77µm high.

This example proves that the UV radiation penetrated the entire depth of the film and that the process of the invention is suitable for the production of thick, multi-mode waveguides.

The results from Example 2 are surprising in that the high acid concentration used to hydrolyse the methoxy groups failed to significantly affect the efficiency of the photocuring reaction. It is standard practice in the manufacture of epoxy resins to remove HCl by products since they cause undesirable ring opening reactions which, in turn, adversely affects the efficiency of subsequent crosslinking reactions.

Alkoxysilanes are convenient precursors for the production of the above polymers because:
a) They can be processed by simple atmospheric pressure techniques. b) They are available in a wide variety of forms with many different reactive moieties, e.g. epoxide, mercaptan, vinyl, amine etc.

### Example 4

A commercially available photocurable bisphenol-A epoxy resin (XPSU8 10, from Chestech MicroChem Corp., 1254 Chestnut Street, Newton, MA, USA) was spun onto a wafer at 1500 r.p.m.. The resultant film was approximately 10µm thick. The whole film was exposed to 200 light units to cause partial cross-linking. The waveguides were patterned through a chrome on quartz mask for 900 light units.
At this stage, no waveguide structures were evident. The film was extracted in acetone for 1 hour and the waveguide structures became visible. The soluble material was extracted from the partially cured regions. It is postulated that a refractive index step was produced by the formation of micro-voids in the extracted cladding regions. This example proves that the technology of partial extraction is applicable to wholly organic systems.

A preferred embodiment of the invention would be to employ a thermal partial cross-linking reaction, for example via amine moieties, since this would provide a more uniform degree of reticulation than is possible by photo-curing, which causes preferential cross-linking at the surface closest to the UV light source.

### Example 5

9g 3-Glycidoxypropyl-Trimethoxysilane
1g Dimethyl-diethoxysilane
0.75g Diphenyl-dimethoxysilane

The ingredients listed above were placed in a round-bottomed flask and were stirred for 15 minutes. 2ml of 0.1M HCl were then added dropwise to the mixture being stirred over a period of 20 minutes.

The reaction mixture was then brought to the point of reflux and 2ml of iso-propyl-alcohol were then added dropwise over a period of 5 minutes. This entire mixture was then refluxed for 3 hours and was then cooled. Another 2ml of 0.1M HCl were then added dropwise while stirring and the mixture was allowed to stir for 1 hour.

Finally, 0.9g of 50% Triarylsulphonium-hexafluoroamtimonate salt in propylene carbonate were added as a photoinitiator. The mixture was stirred for another hour and was then ready for deposition.

The reaction mixture was then coated onto silicon wafer substrate by 'dip-coating'. A withdrawal rate of 1.5mm s⁻¹ was employed. The coated substrates were then dried at 100°C for 2 hours. The whole film was then partially cured by exposing it to 20 light units form a DEK 1600 Exposure System (DEK Printing Machines Ltd., Weymouth, Dorset, U.K.). [For specifications and dosage details see example 1]. Waveguide structures were then photo-patterned using a 'chrome on quartz' contact mask for 200 light units. The coated wafer was then extracted in toluene for 2 hours and was dried under a flow of nitrogen, followed by drying in an oven for 30 minutes at 50°C. After these treatments, the waveguide structures were clearly visible to the naked eye.

The sample was then bulk cured by exposing to a further 200 light units to cure any residual epoxide functional groups.

The words "comprises/comprising" and the words "having/including" when used herein with reference to the present invention are used to specify the presence of stated features, integers, steps or components but does not preclude the presence or addition of one or more other features, integers, steps, components or groups thereof.

## Claims

1. A process of forming a material with at least two regions of differing refractive indices comprising the steps of:
(a) providing an amount of a gelable composition comprising at least one gelable component in a desired form;
(b) exposing the gelable composition to conditions which partially gel the gelable composition so that an amount of ungelled material remains;
(c) exposing at least one discrete region of the partially gelled product of step (b) to conditions which induce more complete gelation of the partially gelled gelable composition so that more of the ungelled material is incorporated into the gel structure in said at least one exposed region than in non-exposed regions; and
(d) removing material not incorporated in the gel structure at least from the non-exposed region; to create a refractive difference between the Material of said at least one exposed region and the material of the non-exposed regions.

2. A process according to claim 1 wherein a second component is provided together with the gelable component, the second component being selected to impart a higher or lower refractive index to that part of the material in which it is incorporated.

3. A process according to claim 1 or claim 2 wherein the material is provided with a step in refractive index between at least two regions of the material.

4. A process according to claim 1 or claim 2 wherein an amount of the second component not bound in the material is extracted by step (d).

5. A process according to any preceding claim wherein an amount of ungelled gelable component is extracted by solvent.

6. A process according to any one of claims 2 to 5 wherein an amount of second component is extracted by solvent.

7. A process according to any preceding claim wherein the gelable component is selected from those which are susceptible to cross-linking.

8. A process according to claim 7 wherein after step (c) has been carried out the discrete region(s) exposed to the conditions have cross-linked to a greater extent.

9. A process according to any preceding claim wherein the gelable composition is gelable by irradiation and/or by exposure to elevated temperatures and/or by exposure to electron or ion beams.

10. A process according to any preceding claim wherein a mask is used to expose at least one discrete region of the product of step (b) to conditions which induce more complete gelation of the partially gelled gelable composition.

11. A process according to claim 9 or claim 10 wherein the gelable composition is gelable by UV irradiation.

12. A process according to any preceding claim wherein the gelable component is selected from the following:
(i) alkyl or acyl substituted alkoxysilanes including:
(3-glycidoxypropyl) trimethoxysilane;
(3-glycidoxypropyl) triethoxysilane;
(3-glycidoxypropyl) methyldimethoxysilane;
(3-glycidoxypropyl) methyldiethoxysilane;
(3-glycidoxypropyl) dimethylmethoxysilane;
(3-glycidoxypropyl) dimethylethoxysilane;
2-(3,4-epoxycyclohexyl) ethyltriethoxysilane;
2-(3,4-epoxycyclohexyl) ethyltrimethoxysilane;
epoxypropoxypropyl terminated polydimethylsiloxanes such as epoxycyclohexylethyl;
methylsiloxane-dimethylsiloxane copolymers;
ethacryloxypropyltrimethoxysilane;
methacryloxypropyltriethoxysilane;
methacryloxypropylmethyldimethoxysilane;
methacryloxypropylmethyldiethoxysilane;
methacryloxymethyltrimethoxysilane;
methacryloxymethyltriethoxysilane; and/or
(ii) the following components:
2-hydroxy ethyl methacrylate;
2-hydroxy 3-methacryloxy propyl methacrylate;
3-hydroxy propyl methacrylate;
tetrahydro furfuryl methacrylate;
zirconium tetramethacrylate;
acryloxypropyltrimethoxysilane;
acryloxypropylmethyldimethoxysilane;
2-hydroxy ethyl acrylate;
3-hydroxy propyl acrylate;
2-hydroxy 3-methacryloxy propyl acrylate;
2-hydroxy 3-acryloxy propyl acrylate;
diethylene glycol diacrylate;
triethylene glycol diacrylate;
tetraethylene glycol diacrylate;
trimethylol propane triacrylate;
1-6-hexanediol diacrylate.

13. A process according to any one of claims 2 to 12 wherein the exposed region(s) has a greater amount of second component bound in the gel and has a higher refractive index than the non-exposed region(s) with lesser amounts of the second component bound in the gel, at a desired wavelength.

14. A process according to any one of claims 2 to 13 wherein the second component comprises solid particles.

15. A process according to claim 14 wherein the second component is provided as a dispersion in the gelable component.

16. A process according to any one of claims 2 to 15 wherein the second component is capable of being bound in the gel structure.

17. A process according to claim 15 wherein the second component is selected from alkyl or acyl substituted alkoxy silanes including:
diphenyldimethoxysilane;
diphenyldiethoxysilane;
diphenyldipropoxysilane;
dimethyldimethoxysilane;
dimethyldiethoxysilane;
dimethyldipropoxysilane;
methylphenyldimethoxysilane;
methylphenyldiethoxysilane;
methylphenyldipropoxysilane;
tetramethoxysilane;
tetraethoxysilane;
tetrapropoxysilane;
phenyltrimethoxysilane;
phenyltriethoxysilane;
phenyltripropoxysilane;
methyltrimethoxysilane;
methyltriethoxysilane;
methyltripropoxysilane.

18. A process according to any preceding claim wherein the refractive index of the exposed region(s) and the non-exposed region(s) is in the range of about 1 to about 6 such as from about 1.3 to about 3.

19. A process according to any preceding claim wherein the difference in the refractive index of the exposed regions(s) and the non-exposed regions is in the range from about 0.001 to about 0.5.

20. A process according to any preceding claim comprising the steps of:
(i) forming a buffer layer on a desired substrate;
(ii) applying a gelable composition comprising a gelable component to the buffer layer so that the gelable composition is in a desired form;
(iii) exposing the gelable composition to conditions which partially gel the gelable composition so that an amount of ungelled material remains;
(iv) exposing at least one discrete area of the partially gelled product of step (iii) to conditions which induce more complete gelation of the partially gelled gelable composition so that more ungelled material is incorporated into the gel structure in the exposed regions than in the non-exposed regions; and
(v) extracting material not incorporated into the gel structure at least from said at least one region not exposed to the conditions of step (iv); to create a refrative difference between the material of said at least one exposed region and the material of the non-exposed regions.

21. A process according to any preceding claim comprising the additional step of providing a protective layer or coating for the material.

22. A material with at least two regions of differing refractive indices obtainable by a process according to any one of claims 1 to 21.

## Patentansprüche

1. Ein Verfahren zum Bilden einer Materialschicht mit wenigstens zwei Bereichen mit unterschiedlichen Brechungsindizes umfassend die folgenden Schritte:
(a) zur Verfügung stellen einer Masse einer gelierbaren Zusammensetzung umfassend wenigstens einen gelierbaren Bestandteil in einer gewünschten Form;
(b) Exponieren der gelierbaren Zusammensetzung gegenüber Bedingungen, welche die gelierbare Zusammensetzung in der gesamte Masse teilweise ein Gel bilden lassen, so daß ein Teil des Materials in nicht-gelförmiger Form verbleibt;
(c) Aussetzen von wenigstens einem diskreten Bereich des teilweise gelförmigen Produktes aus Schritt (b) gegenüber Bedingungen, welche eine vollständigere Gelbildung der teilweise gelförmigen gelierbaren Zusammensetzung induzieren, so daß mehr des nicht-gelförmigen Materials in dem wenigstens einem exponierten Bereich in die Gelstruktur mit aufgenommen wird, als in den nicht-exponierten Bereichen; und
(d) Entfernen des Materials, das nicht in die Gelstruktur mit aufgenommen ist, wenigstens aus dem nicht-exponierten Bereich, um einen Unterschied in der Lichtbrechung zwischen dem Material des wenigstens einen exponierten Bereiches und dem Material der nicht-exponierten Bereiche herzustellen.

2. Ein Verfahren nach Anspruch 1, wobei ein zweiter Bestandteil gemeinsam mit dem gelierbaren Bestandteil zur Verfügung gestellt wird, wobei der zweite Bestandteil so ausgewählt ist, daß er dem Teil des Materials, in den er mit einbezogen wird, einen höheren oder niedrigeren Brechungssindex verleiht.

3. Ein Verfahren nach Anspruch 1 oder Anspruch 2, wobei das Material mit einer Abstufung der Brechungsindizes zwischen wenigstens zwei Bereichen des Materials zur Verfügung gestellt wird.

4. Ein Verfahren nach Anspruch 1 oder Anspruch 2, wobei eine Menge des zweiten Bestandteiles, die im Material nicht gebunden ist, durch Schritt (d) extrahiert wird.

5. Ein Verfahren nach einem vorstehenden Anspruch, wobei eine Menge des nicht gelförmigen gelierbaren Bestandteils mit einem Lösungsmittel extrahiert wird.

6. Ein Verfahren nach einem der Ansprüche 2 bis 5, wobei eine Menge des zweiten Bestandteils mit einem Lösungsmittel extrahiert wird.

7. Ein Verfahren nach einem vorstehenden Anspruch, wobei der gelierbare Bestandteil aus denen ausgewählt ist, die für Quervernetzen empfänglich sind.

8. Ein Verfahren nach Anspruch 7, wobei nachdem Schritt (c) ausgeführt wurde, der/die diskrete(n) Bereich(e), die gegenüber den Bedingungen exponiert waren, in einem größerem Ausmaß quervernetzt ist/sind.

9. Ein Verfahren nach einem vorstehenden Anspruch, wobei die gelierbare Zusammensetzung durch Bestrahlung und/oder durch Exponieren gegenüber erhöhten Temperaturen und/oder durch Exponieren gegenüber Elektronen- oder Ionenstrahlung gelierbar ist.

10. Ein Verfahren nach einem vorstehenden Anspruch, wobei eine Maske verwendet wird, um wenigstens einen diskreten Bereich des Produktes aus Schritt (b) gegenüber Bedingungen zu exponieren, welche eine vollständigere Gelbildung der teilweise gelierbaren Zusammensetzung induzieren.

11. Ein Verfahren nach Anspruch 9 oder Anspruch 10, wobei die gelierbare Zusammensetzung durch UV-Bestrahlung gelierbar ist.

12. Ein Verfahren nach einem vorstehenden Anspruch, wobei der gelierbare Bestandteil ausgewählt ist aus das folgende: oder Acyl-substituierten Alkoxysilanen,
(i) Alkyl- oder Acyl-substituierten Alkoxysilanen, einschließlich:
(3-Glycidoxypropyl)trimethoxysilan;
(3-Glycidoxyprogyl)triethoxysilan;
(3-Glycidoxypropyl)methyldimethoxysilan;
(3-Glycidoxypropyl)methyldiethoxysilan;
(3-Glycidoxypropyl)dimethylmethoxysilan;
(3-Glycidoxypropyl)dimethylethoxysilan;
2-(3)4-Epoxycyclohexyl)ethyltriethoxysilan;
2-(3,4-Epoxycyclohexyl)ethyltrimethoxysilan;
Epoxypropoxypropyl-terminierte Polydimethylsiloxane, so wie Epoxycyclohexylethyl;
Methylsiloxan-dimethylsiloxan-Copolymere;
ethacryloxypropyltrimethoxysilan;
Methacryloxypropyltriethoxysilan;
Methacryloxypropylmethyldimethoxysilan;
Methacryloxypropylmethyldiethoxysilan;
Methacryloxymethyltrimethoxysilan;
Methacryloxymethyltriethoxysilan; und/oder
(ii) die folgenden Bestandteils:
2-Hydroxyethylmethacrylat;
2-Hydroxy-3-methacryloxypropylmethacrylat;
3-Hydroxypropylmethacrylat;
Tetrahydrofurfurylmethacrylat;
Zirconiumtetramethacrylat;
Acryloxypropyltrimethoxysilan;
Acryloxypropylmethyldimethoxysilan;
2-Hydroxyethylacrylat;
3-Hydroxypropylacrylat;
2-Hydroxy-3-methacryloxypropylacrylat;
2-Hydroxy-3-acryloxypropylacrylat;
Diethylenglycoldiacrylat;
Triethylenglycoldiacrylat;
Tetraethylenglycoldiacrylat;
Trimethylolpropantriacrylat;
1-6-Hexanedioldiacrylat.

13. Ein Verfahren nach einem der Ansprüche 2 bis 12, wobei der/die exponierte(n) Bereich(e) mit einer größeren Menge des zweiten Bestandteils gebunden im Gel ausgestattet ist/sind und bei einer gewünschten Wellenlänge einen größeren Brechungssindex als der/die nicht-exponierte(n) Region(en) mit geringeren Mengen des zweiten Bestandteiles gebunden im Gel aufweist/aufweisen.

14. Ein Verfahren gemäß einem der Ansprüche 2 bis 13, wobei der zweite Bestandteil Feststoffpartikel umfaßt.

15. Ein Verfahren nach Anspruch 14, wobei der zweite Bestandteil als eine Dispersion des gelierbaren Bestandteils zur Verfügung gestellt wird.

16. Ein Verfahren gemäß einem der Ansprüche 2 bis 15, wobei der zweite Bestandteil in der Lage ist, in die Gelstruktur mit eingebunden zu werden.

17. Ein Verfahren nach Anspruch 15, wobei der zweite Bestandteil ausgewählt ist aus Alkyl- oder Acyl-substituierten Alkoxysilanen einschließlich:
Diphenyldimethoxysilan;
Diphenyldiethoxysilan;
Diphenyldipropoxysilan;
Dimethyldimethoxysilan;
Dimethyldiethoxysilan;
Dimethyldipropoxysilan;
Methylphenyldimethoxysilan;
Methylphenyldiethoxysilan;
Methylphenyldipropoxysilan;
Tetramethoxysilan;
Tetraethoxysilan;
Tetrapropoxysilan;
Phenyltrimethoxysilan;
Phenyltriethoxysilan;
Phenyltripropoxysilan;
Methyltrimethoxysilan;
Methyltriethoxysilan;
Methyltripropoxysilan.

18. Ein Verfahren nach einem vorstehenden Anspruch, wobei der Brechungsindex des/der exponierten Bereiches/Bereiche und des/der nicht-exponierten Bereiches/Bereiche im Bereich von etwa 1 bis zu etwa 6, so wie von etwa 1,3 bis zu etwa 3 ist.

19. Ein Verfahren nach einem vorstehenden Anspruch, wobei der Unterschied der Brechungssindizes des/der exponierten Bereiches/Bereiche und des/der nicht-exponierten Bereiches/Bereiche im Bereich von etwa 0.001 bis zu etwa 0.5 ist.

20. Ein Verfahren nach einem vorstehenden Anspruch, umfassend die Schritte:
(i) Bilden eine Pufferschicht auf einem gewünschten Substrat;
(ii) Anwenden einer gelierbaren Zusammensetzung umfassend einen gelierbaren Bestandteil auf die Pufferschicht, so daß die gelierbare Zusammensetzung in einer gewünschten Form vorliegt;
(iii) Exponieren der gebildeten gelierbaren Zusammensetzung gegenüber Bedingungen, welche die gelierbare Zusammensetzung teilweise gelieren, so daß eine Menge nicht-gelförmigen Materials verbleibt
(iv) Exponieren von wenigsten einem diskretem Bereich des partiell gelierten Produktes aus Schritt (iii) gegenüber Bedingungen, welche eine vollständigere Gelbildung der teilweise gelierten gelierbaren Zusammensetzung induzieren, so daß in den exponierten Bereichen mehr des nicht gelförmigen Materials in die Gelstruktur mit einbezogen wird als in den nicht-exponierten Bereichen; und
(v) Extrahieren des Materials, das nicht in die Gelstruktur nicht mit einbezogen ist, wenigstens aus dem wenigstens einem Bereich, der den Bedingungen des Schrittes (iv) nicht ausgesetzt war; um einen Unterschied in der Lichtbrechung zwischen dem Material des wenigstens einen exponierten Bereiches und dem Material der nicht-exponierten Bereiche herzustellen.

21. Ein Verfahren nach einem vorstehenden Anspruch, umfassend den zusätzlichen Schritt des zur Verfügung stellens einer Schutzschicht oder einer Beschichtung für das Material.

22. Ein Material mit wenigstens zwei Bereichen mit unterschiedlichen Brechungsindizes erhältlich nach einem Verfahren gemäß einem der Ansprüche 1 bis 21.

## Revendications

1. Procédé de formation d'un matériau ayant au moins deux régions à indices de réfraction différents, comprenant les étapes consistant :
(a) à fournir une quantité d'une composition gélifiable comprenant au moins un constituant gélifiable sous une forme souhaitée ;
(b) à exposer la composition gélifiable à des conditions qui gélifient partiellement la composition gélifiable de sorte qu'il reste une quantité de matériau non gélifié ;
(c) à exposer au moins une région discrète du produit partiellement gélifié de l'étape (b) à des conditions qui provoquent une gélification plus complète de la composition gélifiable partiellement gélifiée de sorte que davantage de matériau non gélifié est incorporé dans la structure de gel dans ladite au moins une région exposée que dans les régions non exposées ; et
(d) à éliminer du matériau non incorporé dans la structure de gel au moins à partir de la région non exposée, pour créer une différence de réfraction entre le matériau de ladite au moins une région exposée et le matériau des régions non exposées.

2. Procédé selon la revendication 1, dans lequel un second constituant est fourni avec le constituant gélifiable, le second constituant étant choisi pour conférer un indice de réfraction plus élevé ou plus bas à la partie du matériau dans lequel il est incorporé.

3. Procédé selon la revendication 1 ou la revendication 2, dans lequel le matériau comporte une différence d'indice de réfraction entre au moins deux régions du matériau.

4. procédé selon la revendication 1 ou la revendication 2, dans lequel une quantité du second constituant non lié dans la matière est extraite par l'étape (d).

5. Procédé selon l'une quelconque des revendications précédentes, dans lequel une quantité de constituant gélifiable non gélifié est extraite par solvant.

6. Procédé selon l'une quelconque des revendications 2 à 5, dans lequel une quantité de second constituant est extraite par solvant.

7. Procédé selon l'une quelconque des revendications précédentes, dans lequel le constituant gélifiable est choisi parmi ceux qui sont aptes à la réticulation.

8. Procédé selon la revendication 7, dans lequel, après avoir effectué l'étape (c), la (les) région(s) discrète(s) exposée (s) aux conditions sont davantage réticulée(s).

9. Procédé selon l'une quelconque des revendications précédentes, dans lequel la composition gélifiable est gélifiable par irradiation et/ou par exposition à des températures élevées et/ou par exposition à des faisceaux d'électrons ou d'ions.

10. Procédé selon l'une quelconque des revendications précédentes, dans lequel un masque est utilisé pour exposer au moins une région discrète du produit de l'étape (b) à des conditions qui provoquent une gélification plus complète de la composition gélifiable partiellement gélifiée.

11. Procédé selon la revendication 9 ou la revendication 10, dans lequel la composition gélifiable est gélifiable par irradiation UV.

12. Procédé selon l'une quelconque des revendications précédentes, dans lequel le constituant gélifiable est choisi parmi les matériaux le suivant:
(i) alcoxysilanes alkyl - ou acyl - substitués incluant :
(3-glycidoxypropyl)triméthoxysilane ;
(3-glycidoxypropyl)triéthoxysilane ;
(3-glycidoxypropyl)méthyldiméthoxysilane ;
(3-glycidoxypropyl)méthyldiéthoxysilane ;
(3-glycidoxypropyl)diméthylméthoxysilane ;
(3-glycidoxypropyl)diméthyléthoxysilane ;
2-(3,4-époxycyclohexyl)éthyltriéthoxysilane ;
2-(3,4-époxycyclohexyl)éthyltriméthoxysilane ;
polydiméthylsiloxanes à terminaisons époxypropoxypropyle tels qu'époxycyclohexyléthyle ;
copolymères méthylsiloxane-diméthylsiloxane ;
méthacryloxypropyltriméthoxysilane ;
méthacryloxypropyltriéthoxysilane ;
méthacryloxypropylméthyldiméthoxysilane ;
méthacryloxypropylméthyldiéthoxysilane ;
méthacryloxyméthyltriméthoxysilane ;
méthacryloxyméthyltriéthoxysilane ; et/ou
(ii) les constituents suivants:
méthacrylate de 2-hydroxyéthyle ;
méthacrylate de 2-hydroxy 3-méthacryloxypropyle ;
méthacrylate de 3-hydroxypropyle ;
méthacrylate de tétrahydrofurfuryle ;
tétraméthacrylate de zirconium ;
acryloxypropyltriméthoxysilane ;
acryloxypropylméthyldiméthoxysilane ;
acrylate de 2-hydroxyéthyle ;
acrylate de 3-hydroxypropyle ;
acrylate de 2-hydroxy 3-méthacryloxypropyle ;
acrylate de 2-hydroxy 3-acryloxypropyle ;
diacrylate de diéthylèneglycol ;
diacrylate de triéthylèneglycol ;
diacrylate de tétraéthylèneglycol ;
triacrylate de triméthylolpropane ;
diacrylate de 1-6-hexanediol.

13. Procédé selon l'une quelconque des revendications 2 à 12, dans lequel la (les) région(s) exposée(s) a (ont) une plus grande quantité de second constituant lié dans le gel et a (ont) un plus haut indice de réfraction que la (les) région(s) non exposée(s) ayant des quantités moindres du second constituant lié dans le gel, à une longueur d'onde souhaitée.

14. Procédé selon l'une quelconque des revendications 2 à 13, dans lequel le second constituant comprend des particules solides.

15. Procédé selon la revendication 14, dans lequel le second constituant est fourni sous la forme d'une dispersion dans le constituant gélifiable.

16. Procédé selon l'une quelconque des revendications 2 à 15, dans lequel le second constituant est apte à être lié dans la structure de gel.

17. Procédé selon la revendication 15, dans lequel le second constituant est choisi parmi les alcoxysilanes alkylés ou acylés incluant :
diphényldiméthoxysilane ;
diphényldiéthoxysilane ;
diphényldipropoxysilane ;
diméthyldiméthoxysilane ;
diméthyldiéthoxysilane ;
diméthyldiprapoxysilane ;
méthylphényldiméthoxysilane ;
méthylphényldiéthoxysilane ;
méthylphényldipropoxysilane ;
tétraméthoxysilane ;
tétraéthoxysilane ;
tétrapropoxysilane ;
phényltriméthoxysilane ;
phényltriéthoxysilane ;
phényltripropoxysilane ;
méthyltriméthoxysilane ;
méthyltriéthoxysilane ;
méthyltripropoxysilane.

18. Procédé selon l'une quelconque des revendications précédentes, dans lequel l'indice de réfraction de la (des) région(s) exposée(s) et de la (des) région(s) non exposée(s) est dans la gamme d'environ 1 à environ 6, telle que d'environ 1,3 à environ 3.

19. Procédé selon l'une quelconque des revendications précédentes, dans lequel la différence d'indice de réfraction entre la (des) région(s) exposée(s) et la (des) région(s) non exposée(s) est dans la gamme d'environ 0,001 à environ 0,5.

20. Procédé selon l'une quelconque des revendications précédentes, comprenant les étapes consistant :
(i) à former une couche tampon sur un substrat souhaité ;
(ii) à appliquer une composition gélifiable comprenant un constituant gélifiable sur la couche tampon de sorte que la composition gélifiable est sous une forme souhaitée ;
(iii) à exposer la composition gélifiable à des conditions qui gélifient partiellement la composition gélifiable de sorte qu'il reste une quantité de matériau non gélifié,
(iv)à exposer au moins une zone discrète du produit partiellement gélifié de l'étape (iii) à des conditions qui induisent une gélification plus complète de la composition gélifiable partiellement gélifiée de sorte que davantage de matériau non gélifié est incorporé dans la structure de gel dans les régions exposées que dans les régions non exposées ; et
(v) à extraire du matériau non incorporé dans la structure de gel au moins à partir de ladite au moins une région non exposée aux conditions de l'étape (iv), pour créer une différence de réfraction entre le matériau de ladite au moins une région exposée et le matériau des régions non exposées.

21. Procédé selon l'une quelconque des revendications précédentes, comprenant l'étape supplémentaire consistant à fournir une couche protectrice ou un revêtement protecteur pour le matériau.

22. Matériau ayant au moins deux régions d'indices de réfraction différents, pouvant être obtenu par un procédé selon l'une quelconque des revendications 1 à 21.
